# EUROPEAN PATENT APPLICATION

(11) **EP 4 726 753 A1**
(43) Date of publication of application: **15.04.2026**
(21) Application number: 24306669.3
(22) Date of filing: 11.10.2024
(51) Int. Cl.: H01G 4/005, H01G 4/012, H01G 4/228, H01G 4/33, H01G 4/38, H01G 9/00, H01G 9/055, H01G 9/15, H10D 1/00, H10D 1/68, H01G 9/025

(54) **AN ENERGY STORAGE COMPONENT COMPRISING A CAPACITOR OR AN IONIC CAPACITOR, WITH A DISCONTINUOUS BOTTOM ELECTRODE LAYER**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: BUFFLE, Larry, 14000 Caen (FR); SALLAZ, Valentin, 14000 Caen (FR); VOIRON, Frédéric, 14000 Caen (FR); SALVADOR, Violaine, 38054 Grenoble cedex 09 (FR); OUKASSI, Sami, 38054 Grenoble cedex 09 (FR); CAMPO, Alain, 38054 Grenoble cedex 09 (FR)
(74) Representative: Cabinet Beau de Loménie

(57) **Abstract**

A method of manufacturing an integrated electrical device comprising an energy storage component, comprising:
providing a support comprising a porous region (103),
forming an insulating layer (104) having an opening (OP) delimiting a portion of the porous region,
forming a bottom electrode layer (105),
etching the bottom electrode layer such that the bottom electrode layer is removed on the insulating layer and on the top surface of the portion of the porous region, such that there remains a bottom electrode layer inside pores of the portion of the porous region,
forming an intermediate layer (106) comprising a dielectric layer or an ionic conductor,
forming a top electrode layer (107) on the intermediate layer.

## Description

### Field of the Invention

The present invention relates to the field of integration and, more particularly, to electronic products comprising energy storage components such as capacitors or ionic capacitors, and their methods of manufacture.

### Technical Background

Various technologies have been developed for integrating passive components, such as energy storage components, capacitive devices, etc. in/on substrates such as silicon wafers.

There is a general desire to construct integrated energy storage components that provide a high energy storage density. Various approaches have been tried in this regard. In the case of capacitive devices, conventional approaches for increasing capacitance include reducing the thickness of the dielectric layer (subject to the constraint of avoiding dielectric breakdown when the operating voltage is applied) and selecting a material having high dielectric constant as the material of the dielectric layer.

More recently, proposals have been made to form the conductive layers and dielectric layer of an integrated energy storage component conformally over a contoured surface (i.e. forming the conductive layers and dielectric layer so that their shape conforms to the shape of the underlying surface) rather than employing planar layers. Energy storage components of this type may be referred to as "three-dimensional" components (to differentiate them from planar devices). As an example, the PICS technology proposed by Murata Integrated Passive Solutions employs three-dimensional capacitive components and allows high density capacitive components to be integrated into a silicon substrate.

Recently, three-dimensional capacitive components have been fabricated by embedding a Metal-Insulator-Metal (MIM) structure in a porous anodized material, for example in porous anodized alumina (PAA). This technology provides highly-integrated capacitance which can be used for many applications. This technology implements a capacitive stack (for example a MIM stack) in a porous structure which is formed above a substrate such as a silicon wafer. The porous structure may result from the anodization of a thin layer of aluminium deposited above the substrate (e.g. deposited on the substrate or deposited on one or more layers which are themselves formed on the substrate). The anodization process converts the Al into alumina, which is porous (PAA). A mask may optionally be formed over the aluminium layer before anodization takes place, so that the anodization process forms islands of porous material. These components, using a dielectric in the MIM stack, are referred to as capacitors in the present descriptions.

There also exist devices making use of ionic conductors having electronic insulating properties (called ionic conductors in the present application) between electrodes, referred to as ionic capacitors, the ionic conductors are solid-state electrolytes such as LiPON. These ionic capacitors may also be accommodated in a porous anodized alumina structure.

In particular, using solid state electrolytes has been reported to enable planar capacitance densities of around 200-500nF/mm². In such an ionic capacitor, energy is stored via accumulation of mobile charges (ions such as Li+, Na+, etc.) at the electrolyte/electrode interfaces through electrostatic and/or redox processes.

Also, these ionic capacitors may also be accommodated within the pores of a 3D structure so as to increase the capacitance density.

Forming (non-ionic) capacitors or ionic capacitors within the pores of anodic porous oxide, or inside other types of 3D structures, remains difficult to implement.

Usually, above an ionic or non-ionic capacitor formed above a support (for example a porous anodic oxide support), a conductive layer (typically Aluminium) is deposited on the top electrode of the capacitor. This conductive layer is usually delimited by an etching, typically to define an edge outside of a 3D support if one is used. This etching is usually a selective etching configured to stop after etching the top electrode layer on which the conductive layer has been deposited. Ideally, the etching process has no impact on the underlying dielectric or ionic conductor layer.

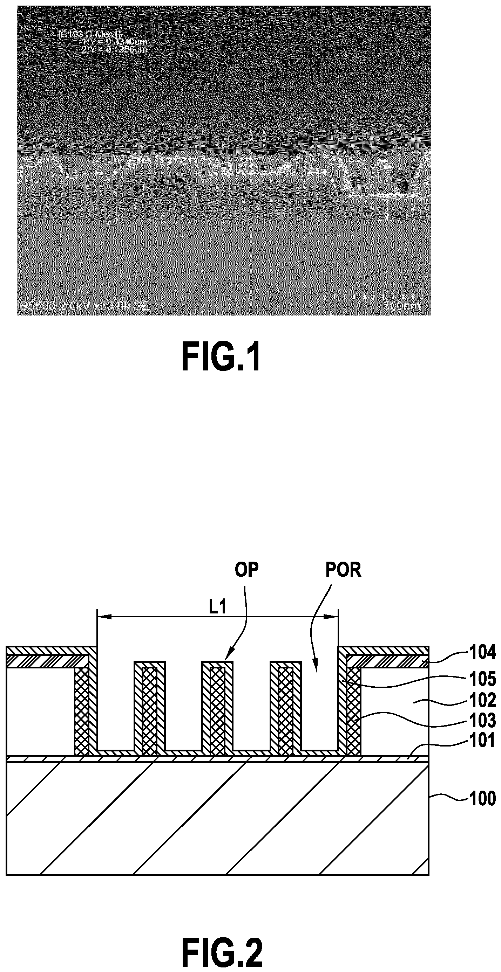

It has been observed, in particular when solid-state electrolytes such as LiPON are used, that the SF6 used to etch the top electrode (typically TiN) can react with the lithium within the LiPON layer and may lead to creating an irregular surface having the aspect of grass. Figure 1 is a SEM image of a such a damaged LiPON layer. Also, these structures have been observed to be LiF-based structures. This implies that the SF6 etching is barely selective, and not suitable for thin layers having a thickness of the order of less than 20nm (such a thickness being suitable for anodic porous oxide devices).

When the intermediate layer, for example comprising LiPON layer is damaged, the top and bottom electrode layers may be electrically shorted together, and other undesirable properties may be obtained.

There exists a need for a solution that prevents these undesirable effects from occurring, especially when using thin dielectric or thin ionic conductor layers (less than 20 nanometres).

The invention has been made in the light of the above problems.

### Summary of the Invention

The invention provides a method of manufacturing an integrated electrical device comprising an energy storage component, comprising:
providing a support comprising a porous region (for example an anodic porous oxide region) including a plurality of substantially straight pores that extend from a top surface of the porous region towards the bottom of the porous region,
forming an insulating layer having an opening delimiting a portion of the porous region,
forming a bottom electrode layer (a continuous layer) conformally inside the pores of the portion of the porous region, on the top surface of the portion of the porous region, and on the insulating layer,
etching the bottom electrode layer such that:
   the bottom electrode layer is removed on at least a portion of the insulating layer comprising the opening, and on the top surface of the portion of the porous oxide (this top surface comprising the top portions of the pores), such that there remains a bottom electrode layer inside pores of the portion of the porous region (after this etching the bottom electrode layer is discontinuous),
   forming an intermediate layer (a continuous layer) comprising a dielectric layer or an ionic conductor (for example a solid-state electrolyte), on the bottom electrode layer (inside the pores), on the top surface of the portion of the porous region, and on the insulating layer (the intermediate layer extends conformally on the bottom electrode layer and extends further than the opening so as to be on the insulating layer, also),
   forming a top electrode layer (a continuous layer) on the intermediate layer (the intermediate layer extends conformally on the intermediate layer and on the intermediate layer where the underlying bottom electrode layer has been etched outside of the opening).

The portion of the insulating layer comprising the opening can be delimited by means of a photolithographic mask so as to remove only a portion of the bottom electrode layer on the insulating layer outside of the opening. By "comprising the opening", what is meant is that there is a continuous portion of the insulating layer surrounding the opening and having an edge that coincides with the edge of the porous region.

Alternatively, the portion of the insulating layer comprising the opening is not delimited by means of a photolithographic mask and the entire bottom electrode layer on the insulating layer is removed.

By conformally, what is meant is that a layer follows the contours of the support onto which it is formed and is not divided into separate portions. For example, the bottom electrode layer follows the contours of the pores of the porous region and extends on the walls of the pores and at the bottom of the pores, and also on the top portions of the pores, prior to the etching step.

The bottom electrode layer extends on the insulating layer which is planar outside of its opening. Consequently, the bottom electrode layer above the insulating layer (or at least above a portion of the insulating layer) presents a surface which is etched at a rate which is faster than the etching rate of the bottom electrode layer within the opening on the portion of the porous region. This also applies to the top surface of the portion of the porous region where the bottom electrode layer is removed.

For example, the etching can be performed by means of a dry etching assisted by a plasma to form reactive species from the etchant gas, eventually to provide heavy ions that are contributing mechanically to the etching. However the plasma cannot form the reactive species inside the pores, thus the etching doesn't take place within the pores.

For example and alternatively, a wet etching can be used. The etchant species can be selected so as to have limited diffusion/renewal within the pores which limits the etching rate inside the pores.

Overall, inside the pores covered with the bottom electrode layer, the etchant particles typically have a low diffusivity which results in a low etching rate. Consequently, it is possible to remove the bottom electrode layer above the insulating layer and on the top portions of the pores while maintaining the bottom electrode layer within the opening in a single etching step, for example without using a photolithography mask (or eventually by using a mask delimiting an opening above the insulating layer).

The bottom electrode layer, initially continuous, is discontinuous after this etching and divided into portions each present within a respective pore. These portions are however electrically connected together through the conductive anodization barrier layer.

The energy storage component is a capacitor or an ionic capacitor, comprising the bottom electrode layer (divided into portions that are electrically connected together), the intermediate layer, and the top electrode layer.

In the obtained structure, the bottom electrode layer is patterned in an etching step which can be mask-less. The top electrode layer extends further than the bottom electrode layer (as it is a continuous layer on the intermediate layer) and, during a further patterning of the top electrode layer and of the intermediate layer, the risk of electrically shorting the top and bottom electrode layer through a damaged intermediate layer is avoided.

According to a particular embodiment, the method comprises forming a conductive layer on the top electrode layer.

This conductive layer can be a current collector of the component. For example, it comprises aluminium.

According to a particular embodiment, the method comprises an etching to delimit a conductive region of the conductive layer above and on the top electrode layer, the perimeter of the conductive region comprising the perimeter of the portion of the porous region,
the etching stopping when reaching the insulating layer.

Thus, in this particular embodiment, this further etching can etch through the conductive region and the intermediate layer. The distance between an edge of the conductive region formed through this etching, and an edge of the opening of the insulating layer, ensures that no electrical short circuit can appear between the top and bottom electrodes.

For example, this further etching can delimit the conductive region so that its perimeter is comprised within the perimeter of the portion of removed bottom electrode layer above the portion of the insulating layer (when a mask is used). Preferably, these two perimeters are spaced apart to avoid electrically shorting the top and bottom electrodes.

According to a particular embodiment, etching to delimit a conductive region of the conductive layer is a non-selective etching.

This particular embodiment facilitates delimiting the conductive region and the top electrode layer.

According to a particular embodiment, etching to delimit a conductive region of the conductive layer and/or etching the bottom electrode layer comprises an ion beam etching.

Ion beam etching has been observed to be particularly adapted to remove the bottom electrode layer on the planar surfaces while having a low etching rate within the pores.

According to a particular embodiment, etching to delimit a conductive region of the conductive layer and/or etching the bottom electrode layer comprises a single etching step.

According to a particular embodiment, during etching the bottom electrode layer, the entire bottom electrode layer is exposed.

In other words, no photolithography mask is used when the bottom electrode layer is etched and the entire bottom electrode layer is exposed to the etchant.

The invention is of course not limited to this embodiment and a mask can be used to delimit the portion of the bottom electrode layer to be removed above the insulating layer.

The invention also provides an integrated electrical device comprising an energy storage component, comprising:
a support comprising a porous region including a plurality of substantially straight pores that extend from a top surface of the porous region towards the bottom of the porous region,
an insulating layer having an opening delimiting a portion of the porous region,
a bottom electrode layer arranged conformally inside the pores of the portion of the porous region, the bottom electrode layer of a pore having an edge coinciding with the top surface of the portion of the porous region (the bottom electrode layer is discontinuous, is not present on the top portions of the pores, and it is also not present on the insulating layer or on at least a portion of the insulating layer comprising the opening),
an intermediate layer comprising a dielectric layer or an ionic conductor, arranged on the bottom electrode layer, on the top surface of the portion of the porous region, and on the insulating layer (as it is not covered by the bottom electrode layer),
a top electrode layer arranged on the intermediate layer.

This integrated electrical device can be obtained by any embodiment of the above defined method.

According to a particular embodiment, the device further comprises a conductive region on the top electrode layer, the edge (for example a lateral edge when the device is observed from the top) of the conductive region being spaced apart from the bottom electrode layer by a distance of at least the thickness of the conductive region.

In this particular embodiment, the edge of the conductive region is always spaced apart from the bottom electrode layer (when observed from the top). For example, this can result in the edge of the conductive region being spaced apart from the edge of the opening of the insulating layer by said distance. Also, if there remains a portion of bottom electrode layer on the insulating layer, this portion is also spaced apart from the edge of the conductive layer. This avoids electrically shorting the top and bottom electrodes.

### Brief Description of the Drawings

Further features and advantages of the present invention will become apparent from the following description of certain embodiments thereof, given by way of illustration only, not limitation, with reference to the accompanying drawings in which:
- Figure 1, already described, is an image of a damaged LiPON layer,
- Figure 2 is a schematic representation of a support with a bottom electrode layer,
- Figure 3 shows the structure of figure 2 after an etching,
- Figure 4 shows a conductive layer formed on the device of figure 3,
- Figure 5 shows sidewalls being formed to obtain a conductive region, and
- Figure 6 shows an additional conductive region formed on the device of figure 5.

### Detailed Description of Example Embodiments

We will now describe energy storage components such as capacitors and ionic capacitors, along with the methods and steps used to obtain these capacitors and ionic capacitors. In particular, we will describe the use of a buffer layer arranged on a bottom electrode layer. The invention is however not limited to this configuration and also applies to the use of a buffer layer arranged on an intermediate layer.

Figure 2 is an exemplary device comprising a substrate 100. This substrate can comprise a semiconductor region (typically silicon), or also glass or other materials. In particular, the substrate 100 can comprise a conductive layer at the level of its top surface that is configured to act as a current collector.

In the present description, a porous region is formed by anodization of a metal, i.e. it is an anodic porous oxide region. The invention also applies to other types of porous regions.

Above the substrate of figure 2, an anodization barrier layer 101 (tungsten, for example) has been deposited.

On the anodization barrier layer, a metal layer 102, typically comprising aluminium has been deposited. The material of this layer should be selected so as to allow forming straight pores that extend from the top surface of the metal layer to the anodization barrier layer.

Here, a portion of the metal layer has been anodized to obtain straight pores POR inside anodic porous oxide region 103 that extend vertically on the figure so as to reach the anodization barrier layer (as disclosed in document WO 2015/063420). Alternatively, the entire metal layer can be anodized and only a subset of pores will be used to accommodate the subsequently described stack of layers.

An insulating layer 104 has been formed above the metal layer 102. This insulating layer can be formed on the metal layer 102 or on the anodic porous oxide region (in particular if the metal layer has been entirely transformed into anodic porous oxide) or above a hard-mask acting as anodization mask to delimit a portion of the metal layer to be anodized. When deposited above an anodization mask, insulating layer 104 can be analogous to the second hard mask described in document EP 3567645.

An opening OP has been formed in the insulating layer 104, that opens onto a portion of the anodic porous oxide (or that opens onto the entire anodic porous oxide region). This opening has a diameter L1 (its greatest horizontal width).

Above this structure, a bottom electrode layer 105 has been deposited in a conformal manner, for example by ALD. This layer may comprise TiN or other conductive materials. The bottom electrode layer is continuous at this stage, it covers the walls of the pores, the top portion of the pores, the bottom of the pores (where it is in contact with anodization barrier layer 101), and on the insulating layer 104.

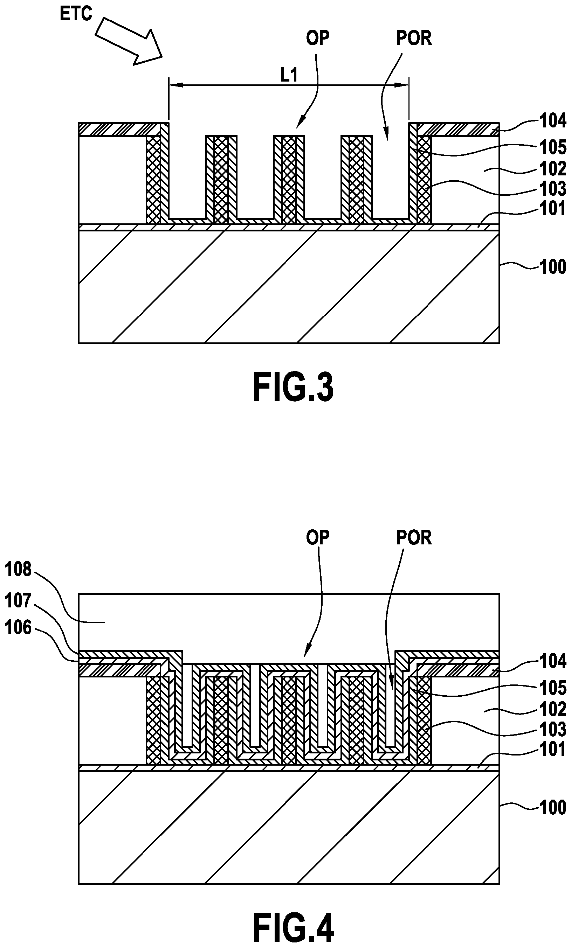

Figure 3 shows the structure of figure 2 after an etching of the bottom electrode layer has been performed, the etching being represented by an arrow referenced ETC.

For example, this etching is a non-selective etching such as an ion beam etching and it is performed without a photolithography mask being used.

The etching is configured so that the etchant will have a low diffusivity inside the pores covered with the bottom electrode layer. The etchant will however diffuse easily on the planar surfaces above the insulating layer outside of the opening, and on the top portions of the pores (i.e. the top surface of the portion of the anodic porous oxide region), where the bottom electrode layer is removed.

In an alternative embodiment, not shown, a mask is used to delimit a portion of the bottom electrode layer to be removed above the insulating layer. This mask will delimit a portion of the insulating layer. For example, this mask can be a photoresist mask with an opening including the opening of the insulating layer (when observed from the top).

Figure 4 shows the structure of figure 3 after a plurality of conformal depositions have been carried out. An intermediate layer 106, here a dielectric layer or ionic conductor layer has been deposited in a conformal manner (for example by ALD). For example, this layer may comprise at least one material selected from the group including SiₓO_{y}, AlₓO_{y}, HfₓO_{y}, ZrₓO_{y}, TiₓO_{y}, LiₓR_{y}O_{z}Nₓ₁, Li_{X}Si_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K. A combination of these materials may also be considered for the intermediate layer.

The intermediate layer is deposited directly on the bottom electrode layer inside the pores (on the walls and at the bottom), directly on the anodic porous oxide at the level of the top surface of the portion of the anodic porous oxide region, and on the insulating layer.

On the intermediate layer, a top electrode layer 107 has been deposited in a conformal manner. This top electrode layer may be analogous to the bottom electrode layer and it may also contain TiN.

The stacks formed by the bottom electrode layers, the intermediate layer, and the top electrode layer form an energy storage component such as a capacitor or an ionic capacitor (depending on the material of the intermediate layer). All the bottom electrode layer portions of each pore are electrically connected together through the conductive anodization barrier layer 101.

It should be noted that the absence of bottom electrode layer at the level of the top of the pores avoids concentration of the electrical field within the intermediate layer where the geometry is narrow.

Above the top electrode layer, a conductive layer 108 which may comprise aluminium has been deposited.

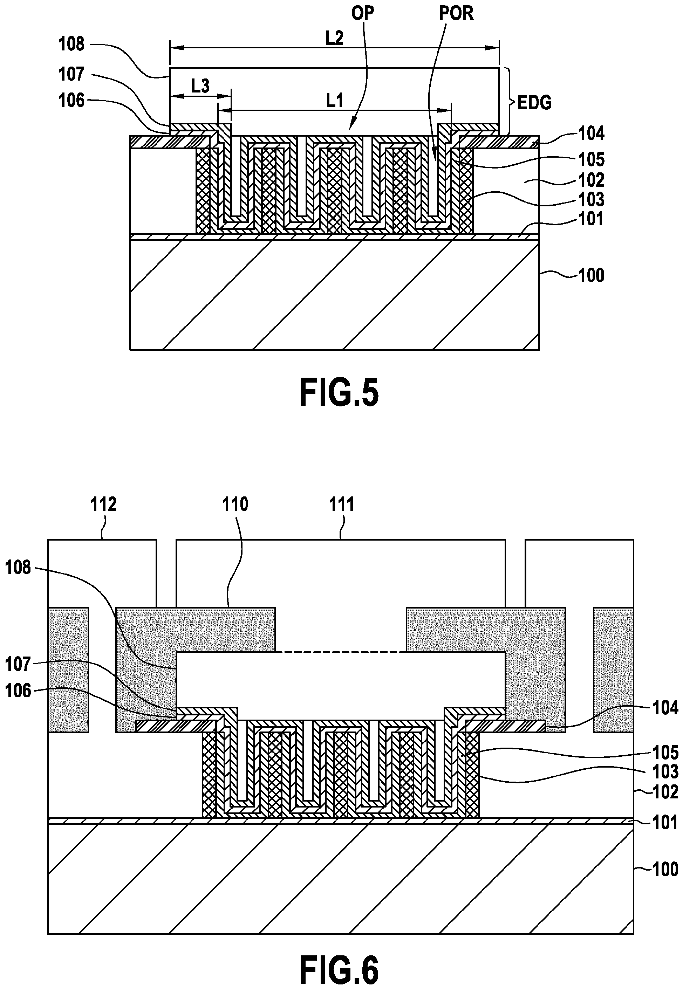

Figure 5 shows the structure of figure 4 in which the conductive layer 108 has been patterned by an etching to delimit a conductive region of the conductive layer 108. This etching stops when reaching the insulating layer 104 and consequently etches through the top electrode layer and the intermediate layer. Here, the conductive region has a perimeter (for example observed from the top) comprising the perimeter of the portion of the anodic porous oxide region (coinciding with the opening). In other words, the conductive region fully covers the opening, and the conductive region has a diameter L2 which is greater than L1.

The etching step illustrated on this figure defines an edge EDG of the conductive region, the intermediate layer, and the top electrode layer. The distance L3 between edge EDG and the edge of the opening OP is selected so as to prevent electrically shorting the top and bottom electrode layers, should the intermediate layer be damaged at the level of edge EDG during the etching step shown on this figure. For example, L3 is at least the thickness of the conductive region.

It should be noted that this etching can be analogous to the etching described in reference to figure 3 and can also be an ion beam etching. In particular, this etching is advantageous as it is non-selective.

Subsequently, and as shown on figure 6, an insulating region 110 can be formed to delimit electrical contacts that are filled with an additional conductive region 111 (typically aluminium) above and in contact with the conductive region 108. Also, the insulating region may have other openings filled with another additional conductive region 112 so as to contact the metal region 102 and the bottom electrode layer through the barrier layer 101. An electrical contact is therefore formed between the bottom electrode layer, the anodization barrier layer, the metal region, and this another additional conductive region 112.

In an alternative embodiment, not represented, the metal layer 102 has been completely anodized, and the bottom electrode layer is connected to the additional conductive region 112 through another porous region acting as a via comprising an electrically conductive material extending from the bottom to the top of the pores of this another porous region, also through the barrier layer 101.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A method of manufacturing an integrated electrical device comprising an energy storage component, comprising:
providing a support comprising a porous region (103) including a plurality of substantially straight pores (POR) that extend from a top surface of the porous region towards the bottom of the porous region,
forming an insulating layer (104) having an opening (OP) delimiting a portion of the porous region,
forming a bottom electrode layer (105) conformally inside the pores of the portion of the porous region, on the top surface of the portion of the porous region, and on the insulating layer,
etching the bottom electrode layer such that the bottom electrode layer is removed on at least a portion of the insulating layer comprising the opening and on the top surface of the portion of the porous region, such that there remains a bottom electrode layer inside pores of the portion of the porous region,
forming an intermediate layer (106) comprising a dielectric layer or an ionic conductor, on the top surface of the portion of the porous region, and on the bottom electrode layer and on the insulating layer,
forming a top electrode layer (107) on the intermediate layer.

2. The method of claim 1, further comprising forming a conductive layer (108) on the top electrode layer.

3. The method of claim 2, further comprising an etching to delimit a conductive region of the conductive layer above and on the top electrode layer, the perimeter of the conductive region comprising the perimeter of the portion of the porous region,
the etching stopping when reaching the insulating layer.

4. The method of claim 3, wherein etching to delimit a conductive region of the conductive layer is a non-selective etching.

5. The method of claim 4, wherein etching to delimit a conductive region of the conductive layer and/or etching the bottom electrode layer comprises an ion beam etching.

6. The method of any one of claims 1 to 5, wherein etching to delimit a conductive region of the conductive layer and/or etching the bottom electrode layer comprises a single etching step.

7. The method of any one of claims 1 to 6, wherein during etching the bottom electrode layer, the entire bottom electrode layer is exposed.

8. An integrated electrical device comprising an energy storage component, comprising:
a support comprising a porous region (103) including a plurality of substantially straight pores (POR) that extend from a top surface of the porous region towards the bottom of the porous region,
an insulating layer (104) having an opening (OP) delimiting a portion of the porous region,
a bottom electrode layer (105) arranged conformally inside pores of the portion of the porous region, the bottom electrode layer of a pore having an edge coinciding with the top surface of the portion of the porous region,
an intermediate layer (106) comprising a dielectric layer or an ionic conductor, arranged on the bottom electrode layer, on the top surface of the portion of the porous region, and on the insulating layer,
a top electrode layer (107) arranged on the intermediate layer.

9. The integrated electrical device of claim 8, further comprising a conductive region on the top electrode layer, the edge of the conductive region being spaced apart from the bottom electrode layer by a distance of at least the thickness of the conductive region.
